# EUROPEAN PATENT SPECIFICATION

(11) **EP 3 404 432 B1**
(45) Date of publication and mention of the grant of the patent: **03.07.2024**
(21) Application number: 18275055.4
(22) Date of filing: 24.04.2018
(51) Int. Cl.: G01R 31/327, H01H 47/00, B60L 3/04, B60L 3/12, B60L 58/10, B60L 3/00, G01R 31/00, H02J 7/00

(54) **METHOD AND SYSTEM FOR DETECTING RELAY ADHESION**
VERFAHREN UND SYSTEM ZUR ERKENNUNG VON RELAISHAFTUNG
PROCÉDÉ ET SYSTÈME POUR DÉTECTER UN COLLAGE DE RELAIS

(30) Priority: 26.04.2017 CN 201710281788; 20.04.2018 US 201815958284
(43) Date of publication of application: 21.11.2018
(73) Proprietor: Contemporary Amperex Technology Co., Limited, Ningde, Fujian 352100 (CN)
(72) Inventor: Zhao, Fei, Ningde City, Fujian PRC 352100 (CN); Wu, Xing, Ningde City, Fujian PRC 352100 (CN); Chen, DeQing, Ningde City, Fujian PRC 352100 (CN)
(74) Representative: Ran, Handong

(56) References cited:
- DE-A1-102009 047 104
- JP-A- 2000 134 707
- JP-A- 2013 169 087
- US-A1- 2007 139 005
- US-A1- 2013 009 648
- US-A1- 2016 146 901

## Description

### CROSS-REFERENCE TO RELATED APPLICATION(S)

### BACKGROUND

### Field

The present invention relates to the field of circuit technology, and in particular to a method and system for detecting an adhesion of a relay.

### Background

Electric vehicles are powered by an on-board electrical power source. In particular, power is generated by a motor, and as such electrical vehicles have a much smaller negative impact on the environment than conventional vehicles. Therefore, electric vehicles have broad appeal.

Since an electric vehicle uses mainly electric energy, a high voltage circuit that provides power is an important part of an electric vehicle. The high voltage circuit may include a battery pack and one or more relays, including a main negative relay connected to the negative battery of the battery pack. When the high voltage circuit is working properly, people in the vehicle are kept safe from the high voltage.

Specifically, when the high voltage circuit is in working condition, if the vehicle is in a collision, the high voltage circuit is opened using the main negative relay to prevent the high voltage circuit from endangering the people in the vehicle. However, after prolonged use, the main negative relay may have a malfunction of adhesion, with the result that the high voltage circuit cannot be opened, thus posing a safety hazard to the people in the vehicle.

US 2007/139005 A1 discloses a power supply device and method of controlling the same.

US 2016/146901 A1 discloses a contactor failure determining method and contactor failure determining device.

JP 2013169087 A discloses an abnormality detecting device of power supply device and electric drive device of rotating electric machine provided with the same.

JP 2000134707 A discloses a power supply controller.

US 2013/0009648 A1 discloses a battery management system and method of controlling the same.

DE 102009047104 A1 discloses diagnosis of relays in a battery.

### SUMMARY

In accordance with the present invention, there is provided a method as set out in claim 1 and a system as set out in claim 6. The method and system disclosed may be used to prevent the potential safety hazard existing in the existing technology caused by the adhesion malfunction of the main negative relay of an electric vehicle high voltage circuit.

One or more embodiments of the present application provide a method for detecting an adhesion malfunction of a relay.

One or more embodiments of the present invention provides a system configured to detect an adhesion malfunction of a relay.

The one or more embodiments of the present application have the advantages that when the first relay and the second relay are open and the third relay is closed, a determination of whether a change in the value of the second voltage measured across the load within a specified time period meets a specified condition may be used to diagnose whether the second relay has an adhesion issue. In the one or more embodiments of the present application, by measuring the change in the sampled voltages external to the second relay, an adhesion of the second relay can be diagnosed, so that corrective action may be promptly taken. In this way, it may be possible to prevent the potential safety hazard caused by a failure of the high voltage circuit to open in a timely manner due to the adhesion malfunction of the second relay when the second relay has been in prolonged use, thereby improving the safety performance of an electric vehicle using the high voltage circuit.

### BRIEF DESCRIPTION OF THE DRAWINGS

In order to more clearly describe the technical solutions presented in the one or more embodiments of the present application, the drawings for the one or more embodiments are briefly described below. The detailed description set forth below accompanied by the drawings represents only some possible embodiments of the present application. One of ordinary skill in the art may readily modify these accompanying drawings without inventive skills to represent other embodiments of the present application.
Figure 1 is an exemplary diagram of a high voltage circuit of an electric vehicle.
Figure 2 is a schematic view of the mechanism for detecting an adhesion of a relay provided in one or more embodiments of the present application.
Figure 3 is a first exemplary flow chart of a method for detecting an adhesion of a relay provided in one or more embodiments of the present application.
Figure 4 is a second exemplary flow chart of a method for detecting an adhesion of a relay provided in one or more embodiments of the present application.
Figure 5 is a third exemplary flow chart of a method for detecting an adhesion of a relay provided in one or more embodiments of the present application.
Figure 6 is a fourth exemplary flow chart of a method for detecting an adhesion of a relay provided in one or more embodiments of the present application.
Figure 7 is a functional block diagram of a system for detecting an adhesion of a relay provided in one or more embodiments of the present application.

### DETAILED DESCRIPTION

In order to allow a better understanding of the technical solutions of the present application, embodiments of the present application will be described in detail below with reference to the accompanying drawings.

Other embodiments may be readily obtained by a person of ordinary skill in the art on the basis of the embodiments described in the present application without inventive skills and all these embodiments still fall within the scope of the present application.

One or more embodiments of the present application provide a method for detecting an adhesion of a relay. The method for detecting an adhesion of a relay can be implemented using an application (APP). In one aspect, a battery management system (BMS) of an electric vehicle may implement a corresponding function of detecting an adhesion of a relay by installing and running the application.

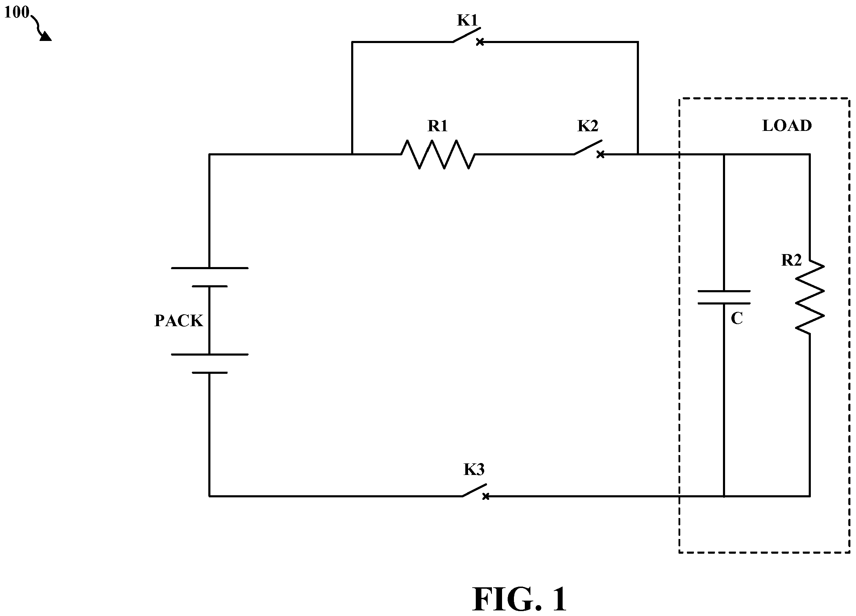

It should be noted that the method for detecting the adhesion of a relay provided by one or more embodiments of the present application may be applied to a high voltage circuit. Figure 1 is a schematic view of a high voltage circuit in an electric vehicle. In reference to Figure 1, the high voltage circuit 100 includes a circuit formed by a battery pack PACK, a first relay K1, a load (including a capacitor C and a second resistor R2 connected in parallel with the capacitor C), and a second relay K3. The first relay K1 is connected to a positive electrode of the battery pack PACK having a voltage V, and the second relay K3 is connected to a negative electrode of the battery pack PACK. In Figure 1, the high voltage circuit 100 further includes a series branch formed by a third relay K2 and a first resistor R1, where the series branch is connected in parallel with the first relay K1. The first relay K1 is a main positive relay, the second relay K3 is a main negative relay, the third relay K2 is a pre-charge relay, and the first resistor R1 is a pre-charge resistor.

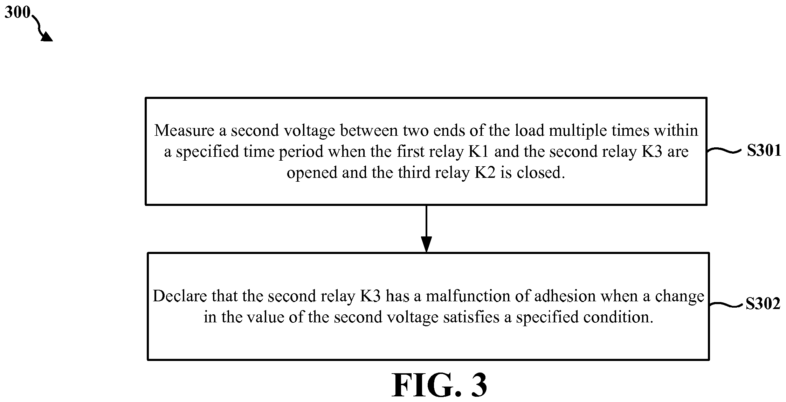

Figure 3 is a first exemplary flow chart of a method for detecting an adhesion of a relay provided in one or more embodiments of the present application. As shown in Figure 3, the method 300 for detecting an adhesion of a relay may include the steps or blocks described herein. In block S301, the method measures a second voltage across the load multiple times within a specified time period when the first relay K1 and the second relay K3 are open and the third relay K2 is closed. In block S302, the method declares that the second relay has a malfunction of adhesion when a change in the value of the second voltage satisfies a specified condition. The specified condition may include: 1) the number of instances when a percentage increase in the second voltage measured in two consecutive sampling times exceeds a second threshold value is N over the specified time period, where N is a specified natural number; and 2) after the specified time period, a ratio of the second voltage to the voltage of the battery pack is greater than a third threshold value. In one aspect, the second voltage may be acquired by an acquiring circuit in real time.

As shown in Figure 3, if the first relay K1 and the second relay K3 are open and the third relay K2 is closed, the method determines whether the change in the value of the second voltage measured across the load multiple times within a specified time period satisfies a specified condition to detect whether the second relay K3 has an adhesion malfunction. Using the change in the sampled voltages external to the second relay K3, an adhesion malfunction of the second relay K3 may be detected and corrective action may be promptly taken. These actions prevent the potential safety hazard caused by a failure of the high voltage circuit 100 to open in a timely manner due to the adhesion malfunction of the second relay K3 when the second relay K3 has been in prolonged use, and improves the safety performance of an electric vehicle using the high voltage circuit 100.

In addition, in an aspect of the embodiment shown in Figure 3, software may operate on the sampled voltages to determine whether the second relay K3 has an adhesion issue. Thus, there is no need to add extra hardware devices or to increase the complexity and cost of the circuits, keeping the cost low and making the method easy to use.

Moreover, in an aspect of the embodiment shown in Figure 3, there is no need to measure the voltage from the negative electrode of the battery, allowing the second voltage to be measured by a variety of acquiring circuits. Because many types of chips or acquiring circuits may be used without the complexity associated with trying to measure voltages at the negative electrode, the method has a wide range of applications.

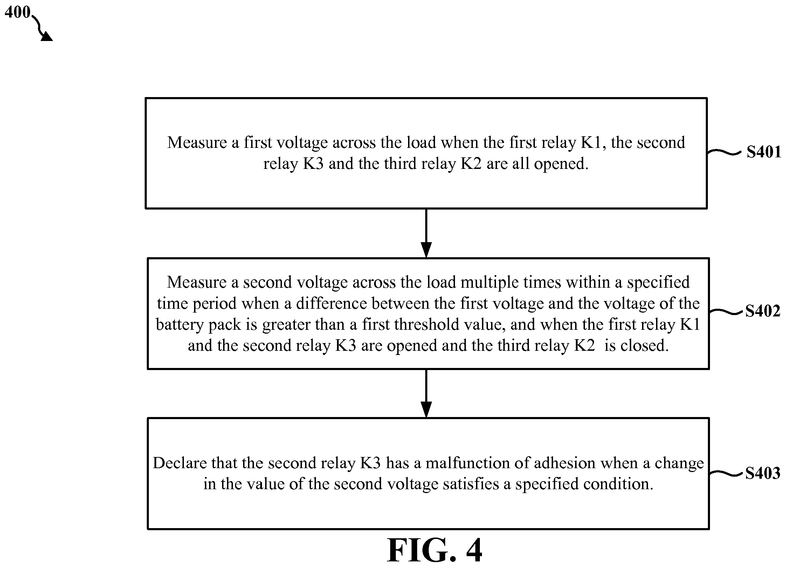

Figure 4 is a second exemplary flow chart of a method for detecting an adhesion of a relay provided in one or more embodiments of the present application. As shown in Figure 4, the method 400 for detecting an adhesion of a relay may include the steps or blocks described herein. In block S401, the method measures a first voltage across the load when the first relay K1, the second relay K3 and the third relay K2 are all opened. In block S402, the method performs the following step when a difference between the first voltage and the voltage of the battery pack is greater than a first threshold value: measure a second voltage across the load multiple times within a specified time period when the first relay K1 and the second relay K3 are open and the third relay K2 is closed. In block S403, the method declares that the second relay has a malfunction of adhesion when the change in the value of the second voltage satisfies a specified condition. The first voltage may be acquired by an acquiring circuit in real time.

In block S402, the difference between the first voltage and the voltage of the battery pack may include a ratio of the first voltage to the voltage of the battery pack, or a difference in the voltages between the first voltage and the voltage of the battery pack. In one aspect, when the difference is the ratio of the first voltage to the voltage of the battery pack, the first threshold value may be 50%. In one aspect, determining if the difference between the first voltage and the voltage of the battery pack is greater than a first threshold value may include determining if the ratio of the first voltage to the voltage of the battery pack is less than a threshold such as 50%. In one aspect, when the difference between the first voltage and the voltage of the battery pack is smaller than the first threshold value, the difference between the first voltage and the voltage of the battery pack is relatively small. In such case, even if the second relay K3 has an adhesion malfunction, because the rising time of the second voltage to span the small difference in the voltage may be short, it may not be easy to accurately detect the adhesion of the second relay K3. However, when the difference between the first voltage and the voltage of the battery pack is greater than the first threshold value, the difference between the first voltage and the voltage of the battery pack is relatively large. In such case, when the second relay K3 has an adhesion malfunction, because the rising time of the second voltage to span the larger difference in the voltage is relatively long, it may be easier to accurately detect the adhesion of the second relay K3.

Thus, in the embodiment shown in Figure 4, when the difference between the first voltage and the voltage of the battery pack is greater than the first threshold value, the method may measure the second voltage. By measuring the change in the value of the second voltage, the method may detect whether the second relay K3 has an adhesion malfunction. Because there may be a longer time to determine an increase in the second voltage than when the difference between the first voltage and the voltage of the battery pack is less than the first threshold value, the method may more accurately determine whether the second relay K3 has an adhesion malfunction.

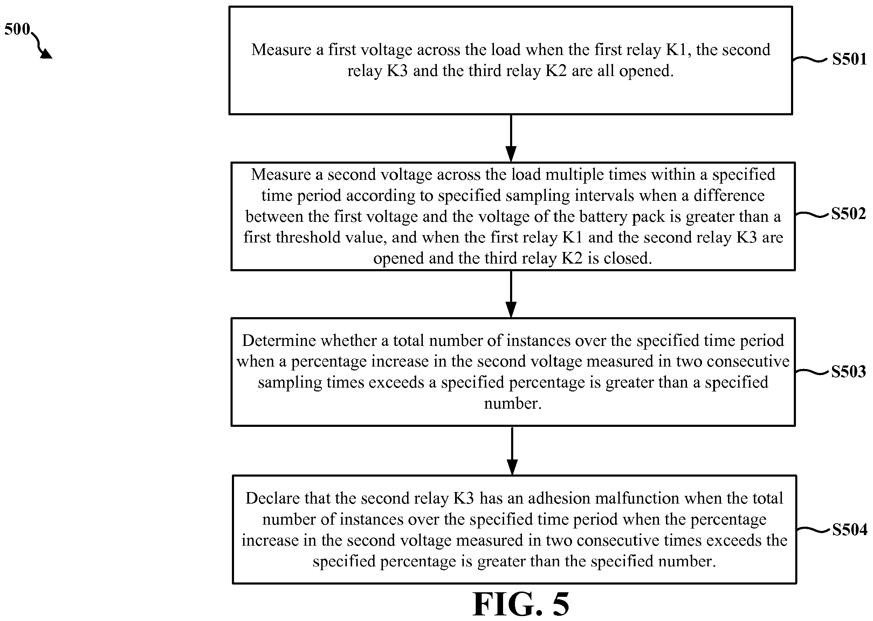

Figure 5 is a third exemplary flow chart of a method for detecting an adhesion of a relay provided in one or more embodiments of the present application. As shown in Figure 5, the method 500 for detecting an adhesion of a relay may include the steps described herein. In block S501, the method measures a first voltage across the load when the first relay K1, the second relay K3 and the third relay K2 are all opened. In block S502, the method performs the following step when a difference between the first voltage and the voltage of the battery pack is greater than a first threshold value: measure a second voltage across the load multiple times within a specified time period according to specified sampling intervals when the first relay K1 and the second relay K3 are open and the third relay K2 is closed. In block S503, the method determines whether the total number of instances over the specified time period when a percentage increase in the second voltage measured in two consecutive sampling times exceeds a specified percentage is greater than a specified number. In block S504, the method declares that the second relay K3 has an adhesion malfunction when the total number of instances over the specified time period when the percentage increase in the second voltage measured in two consecutive times exceeds the specified percentage is greater than the specified number.

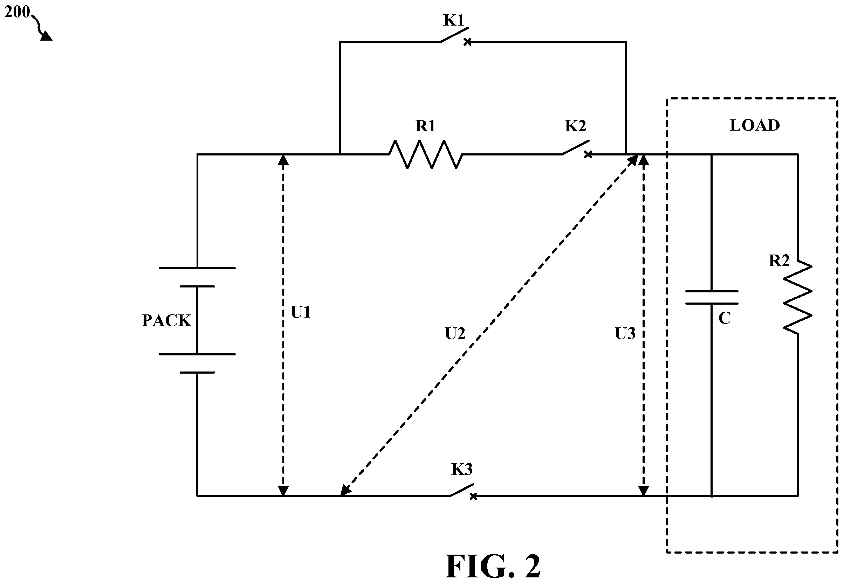

Next, an example will be used to explain the methods described herein in reference to Figure 2. Figure 2 is a schematic view 200 of the mechanism for detecting an adhesion of a relay provided in one or more embodiments of the present application. In Figure 2, the capacitor C may represent the total capacitance of an electric vehicle. In reference to Figure 2, the voltage U1 is the total voltage of the battery pack PACK. In one aspect, U1 may be 400V. Voltage U2 is the voltage external to the first relay K1. Voltage U3 is the voltage external to the second relay K3, that is, the voltage across the capacitor C (or the voltage across the load). Under normal operating condition (after the vehicle has been working at a high voltage for a period of time), when none of the first relay K1, the third relay K2 and the second relay K3 is closed (that is, they are all open), U1 = 400V, U2 = 0V, U3 = 0V.

Then, the third relay K2 may be closed to measure the change in the voltage U3 (that is, the change of the voltage across the capacitor C). During a 100 ms (millisecond) interval or some other interval, the method may sample the U3 voltage multiple time. The method may determine the difference ΔU between each currently sampled value of the U3 voltage (e.g., using a sampling period of 10 ms) with its immediately prior sampled value and determines the percentage increase a% of the currently sampled value relative to its immediately prior sampled value (a% is a percentage increase). For example, if the voltages of two consecutively sampled values of the voltage U3 are 100V and 120V respectively, the percentage increase is (120-100) / 100 = 20%. If the number of instances when the percentage increase a% of two consecutively sampled values is greater than 5% (or other thresholds in other examples) reaches 3 (or other numbers) over the 100 ms interval, and the last sampled value of U3 over the 100 ms interval is greater than or equal to 320V (that is, the ratio of U3 to U1 is greater than 80% or other thresholds), the method may declare that the second relay K3 has an adhesion malfunction; otherwise the second relay K3 does not have an adhesion malfunction.

If the number of instances when the percentage increase of consecutively sampled voltages of voltage U3 exceeds 5% reaches 3 (i.e., N=3) over the 100 ms interval, and if the ratio of the voltage U3 to the voltage U1 is greater than 80% after the 100 ms interval, this result may indicate that the sampled voltage values of the voltage U3 external to the second relay K3 are in a "climbing" profile. This climbing profile strongly suggests that the second relay K3 may have an adhesion problem. Therefore, when the sampled voltage external to the second relay K3 shows a "climbing" profile, the method may determine that the second relay K3 has an adhesion malfunction. Under an abnormal operating condition (for example, continuous high and low voltages), the voltage U3 may be close to the voltage U1. In this case, even if the second relay K3 has an adhesion problem, the problem may not be easily detected because the time for the voltage U3 to rise is too short for the "climbing" profile to be detected and for the adhesion problem to be accurately determined.

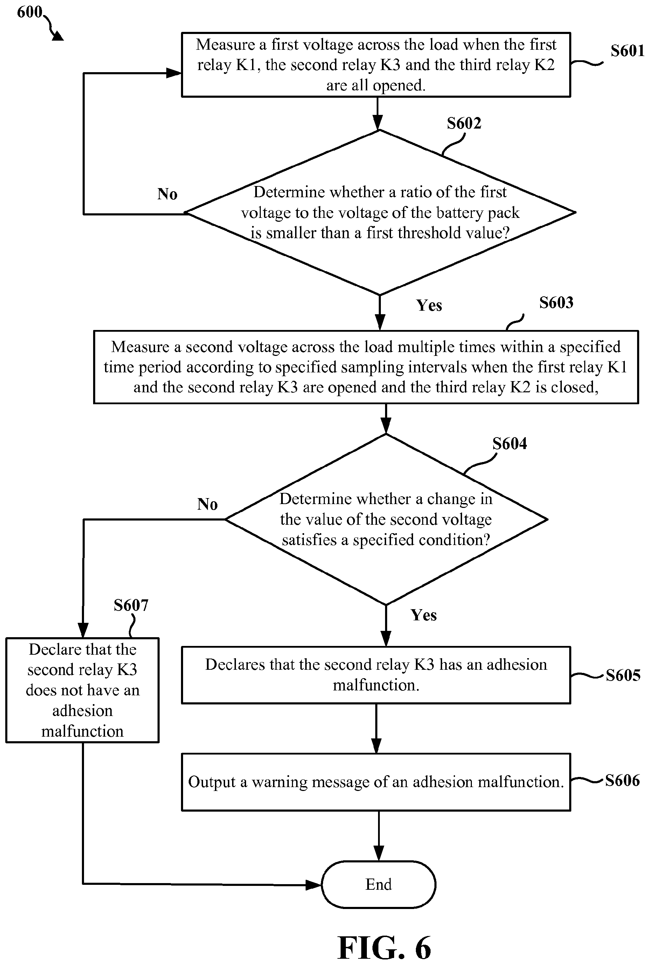

Figure 6 is a fourth exemplary flow chart of a method for detecting an adhesion of a relay provided in one or more embodiments of the present application. As shown in the Figure 6, the method 600 for detecting an adhesion of a relay may include the steps described herein. In block S601, the method measures a first voltage across the load when the first relay K1, the second relay K3 and the third relay K2 are all opened. In block S602, the method determines whether a ratio of the first voltage to the voltage of the battery pack is smaller than a first threshold value. If this ratio is smaller than the first threshold value, the method executes block S603, otherwise the method goes back to block S601. In block S603, when the ratio of the first voltage to the voltage of the battery pack is smaller than the first threshold value, the method measures the second voltage across the load multiple times within a specified time period according to specified sampling intervals when the first relay K1 and the second relay K3 are open and the third relay K2 is closed. In block S604, the method determines whether the change in the value of the second voltage satisfies a specified condition. If the change in the value of second voltage satisfies the specified condition, the method executes S605. Otherwise, if the change in the value of the second voltage does not satisfy the specified condition, the method executes S607. In block S605, the method declares that the second relay has an adhesion malfunction. In block S606, the method outputs a prompt warning message of an adhesion malfunction. In block S607, the method determines that the second relay does not have an adhesion malfunction and the method concludes. The warning message of an adhesion malfunction may be an audio or a visual warning signal. For example, in block S606, the method may output the warning message of an adhesion malfunction as a blinking alarm indicator light, an alarm, or other types of audio or visual warning signals.

According to the methods for detecting an adhesion of a relay provided in the one or more embodiments of the present application, when the first relay K1 and the second relay K3 are open and the third relay K2 is closed, the methods determine whether the change in the value of the second voltage measured across the load within a specified time period meets a specified condition to determine whether the second relay has an adhesion malfunction. By measuring the change in the sampled voltages external to the second relay K3, the methods may diagnose if there is an adhesion of the second relay K3 and may take corrective action. In this way, the methods prevent the potential safety hazard caused by a failure of the high voltage circuit 100 to open in a timely manner due to the adhesion malfunction of the second relay K3 when the second relay K3 has been in prolonged use, thereby improving the safety performance of an electric vehicle using the high voltage circuit 100.

The one or more embodiments of the present application further provide a system for detecting an adhesion of a relay. The system for detecting an adhesion of a relay may implement the blocks of the relay adhesion detection methods provided in the embodiments disclosed herein.

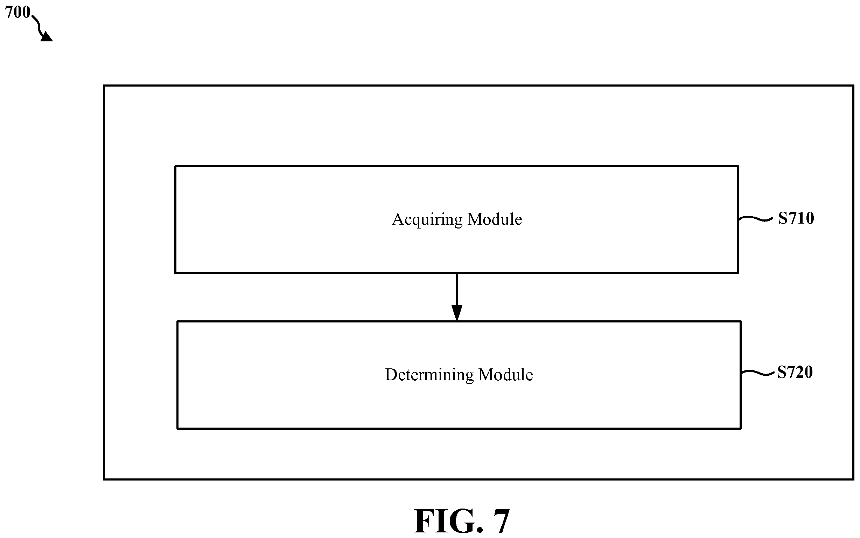

Figure 7 is a functional block diagram of a system 700 configured to detect an adhesion of a relay provided in one or more embodiments of the present application. The system 700 may operate on a high voltage circuit 100 of Figure 1. As shown in Figure 1, the high voltage circuit 100 may include a battery pack, a first relay K1, a load, and a second relay K3. The first relay K1 is connected to a positive electrode of the battery pack, and the second relay K3 is connected to a negative electrode of the battery pack. The high voltage circuit 100 further includes a series branch formed by a third relay K2 and a first resistor R1, where the series branch is connected in parallel with the first relay K1.

As shown in Figure 7, the system 700 configured to detect an adhesion of a relay may include an acquiring module 710 and a determining module 720. The acquiring module 710 may be configured to measure a second voltage across the load multiple times within a specified time period when the first relay K1 and the second relay K3 are open and the third relay K2 is closed. The determining module 720 may be configured to determine that the second relay has an adhesion malfunction when a change in the value of the second voltage satisfies a specified condition,.

In one aspect, the acquiring module 710 may be configured to acquire a first voltage across the load when the first relay K1, the second relay K3, and the third relay K2 are all opened. In one aspect, the acquiring module 710 may be further configured to perform the following step when a difference between the first voltage and the voltage of the battery pack is greater than a first threshold value: measure the second voltages across the load multiple times within the specified time period when the first relay K1 and the second relay K3 are open and the third relay K2 is closed. In one aspect, the acquiring module 710 may be configured to measure the second voltage across the load multiple times within the specified time period according to specified sampling intervals when the first relay and the second relay are open and the third relay is closed. In one configuration, the acquiring module 710 may be implemented in an acquiring circuit, and the determining module 720 may be implemented in a battery management system (BMS).

In one aspect, the determining module 720 maybe further configured to determine that the second relay does not have an adhesion malfunction when the change in the value of the second voltage does not satisfy a specified condition. In one configuration, the system 700 configured to detect an adhesion of a relay may further include an output module, which may be configured to output a prompt warning message of an adhesion malfunction.

In one aspect, the specified condition to be satisfied by the change in the value of the second voltage may include: 1) the number of instances when a percentage increase in the second voltage measured in two consecutive sampling times exceeds a second threshold value is N during the specified time period, where N is a specified natural number; and 2) after the specified time period, a ratio of the second voltage to the voltage of the battery pack is greater than a third threshold value.

In one aspect, when the acquiring module 710 is configured to determine that a difference between the first voltage and the voltage of the battery pack is greater than a first threshold value, the difference may include a ratio of the first voltage to the voltage of the battery pack. In one aspect, the difference may be a difference in the voltages between the first voltage and the voltage of the battery pack. In one aspect, if the difference is the ratio of the first voltage to the voltage of the battery pack, the first threshold value may be 50%. In one aspect, the acquiring module 710 may be configured to determine if the ratio of the first voltage to the voltage of the battery pack is less than 50% to determine if a difference between the first voltage and the voltage of the battery pack is greater than a first threshold value.

The relay adhesion detection system 700 described in this embodiment of the application may implement the methods for detecting the adhesion of the relay in the embodiments disclosed in Figures 3-6. For any part of the adhesion detection system 700 not described in detail in this embodiment, reference may be made to the description for the methods for detecting the adhesion of the relay provided in the embodiments of Figures 3-6.

According to the systems for detecting an adhesion of a relay provided in the embodiments of the present application, when the first relay K1 and the second relay K3 are open and the third relay K2 is closed, the systems are configured to determine whether the change in the value of the second voltage measured across the load within a specified time period meets a specified condition to determine whether the second relay has an adhesion issue. By measuring the change in the sampled voltages external to the second relay K3, the systems may diagnose if there is an adhesion malfunction of the second relay K3, and may take corrective action. In this way, the systems may prevent the potential safety hazard caused by a failure of the high voltage circuit 100 to open in a timely manner due to the adhesion malfunction of the second relay K3 when the second relay K3 has been in prolonged use, thereby improving the safety performance of an electric vehicle using the high voltage circuit 100.

For clarity of description so as not to obscure the inventive concept, some components, devices, units, and steps of the systems and methods of the embodiments of the present application are not described in detail. It is understood that such details are within the knowledge of one of ordinary skill in the art and the detailed description and the accompanying figures of the embodiments of the application disclosed herein fully enable one of ordinary skill in the art to practice the technical solution of the present application.

Disclosed are several exemplary embodiments of the present application. It should be understood that the disclosed systems, devices, and methods may be implemented in other configurations. For example, the division of the systems and methods of the exemplary embodiments into the various functional blocks, components, and steps presented herein is merely one logical functional division and there may be other division(s) for other configurations. For example, multiple units, components, blocks, or steps may be combined, one of them may be integrated into another one, or some of the components may be disabled or steps not executed. In addition, any described mutual coupling, direct coupling, or communication link may be an indirect coupling or a communication link connected through other interfaces, devices or units, and may be implemented in electrical, mechanical or other forms.

Units described as separate components may or may not be physically separate. Components displayed as one unit may or may not be located in one physical unit. That is, a unit may be located in one place or may be distributed across multiple network units. Some or all of the units may be selected according to actual needs to achieve the objective of the systems or methods in one or more embodiments. In addition, multiple functional units in one embodiment may be integrated into one processing unit; each functional unit may exist as separate physical units; or two or more units may be integrated in one unit. A functional unit or an integrated unit may be implemented in hardware, or in hardware plus software.

## Claims

1. A method for detecting an adhesion malfunction of a relay of a high voltage circuit (100), the high voltage circuit (100) comprising a battery pack, a first relay (K1), a load, a series branch, and a second relay (K3), wherein the first relay (K1) is connected between a positive electrode of the battery pack and to a first end of the load, the second relay (K3) is connected between a negative electrode of the battery pack and to a second end of the load, the series branch includes a third relay (K2) and a first resistor (R1) connected in series, the third relay (K2) connecting to the first end of the load, and wherein the series branch is connected in parallel with the first relay (Kl), wherein the load includes a capacitor (C) and a second resistor (R2) connected in parallel with the capacitor (C), the method comprising:
measuring (S401) a first voltage (U3) across the load when the first relay (Kl), the second relay (K3), and the third relay (K2) are all opened;
determining that a difference between the first voltage (U3) and a voltage (U1) of the battery pack is greater than a first threshold value as a precondition to measuring a second voltage (U3),
the method being further **characterized by** determining that the difference between the first voltage and the voltage of the battery pack is greater than a first threshold value by determining that a ratio of the first voltage to the voltage of the battery pack is less than a threshold value of 50%;
measuring (S402) the second voltage (U3) across the load multiple times within a time period when the first relay (K1) and the second relay (K3) are open and the third relay (K2) is closed; and
determining (S403) that the second relay (K3) has the adhesion malfunction when a change in a value of the second voltage (U3) satisfies a condition.

2. The method according to any preceding claim, further comprising:
determining that the second relay (K3) does not have the adhesion malfunction when the change in the value of the second voltage (U3) does not satisfy the condition.

3. The method according to any preceding claim, further comprising:
outputting a warning message of the adhesion malfunction after the second relay (K3) has the adhesion malfunction.

4. The method according to any preceding claim, wherein measuring the second voltage (U3) across the load multiple times within the specified time period comprises measuring the second voltage (U3) across the load according to one or more sampling time intervals.

5. The method according to any preceding claim, wherein the condition comprises:
a number of instances over the time period when a percentage increase in the second voltage (U3) measured in two consecutive sampling times exceeds a second threshold value is N, wherein N is a natural number; and
after the time period, a ratio of a measured second voltage (U3) to the voltage (U1) of the battery pack is greater than a third threshold value.

6. A system (700) comprising a high voltage circuit (100), the system being configured to detect an adhesion malfunction of a relay of the high voltage circuit (100), the high voltage circuit (100) comprising a battery pack, a first relay (Kl), a load, a series branch, and a second relay (K3), wherein the first relay (Kl) is connected between a positive electrode of the battery pack and to a first end of the load, the second relay (K3) is connected between a negative electrode of the battery pack and to a second end of the load, the series branch includes a third relay (K2) and a first resistor (Rl) connected in series, the third relay (K2) connecting to the first end of the load, and wherein the series branch is connected in parallel with the first relay (Kl), wherein the load includes a capacitor (C) and a second resistor (R2) connected in parallel with the capacitor (C), the system comprising:
an acquiring module (710) configured to measure a first voltage (U3) across the load when the first relay (Kl), the second relay (K3), and the third relay (K2) are all opened;
wherein the acquiring module (710) is further configured to determine that a difference between the first voltage (U3) and a voltage (Ul) of the battery pack is greater than a first threshold value as a precondition to the acquiring module (710) being configured to measure a second voltage (U3),
**characterized by** the acquiring module being configured to determine that the difference between the first voltage and the voltage of the battery pack is greater than a first threshold value by determining that a ratio of the first voltage to the voltage of the battery pack is less than a threshold value of 50%;
wherein the acquiring module (710) is further configured to measure the second voltage (U3) across the load multiple times within a time period when the first relay (Kl) and the second relay (K3) are open and the third relay (K2) is closed; and
a determining module (720) configured to determine that the second relay (K3) has the adhesion malfunction when a change in a value of the second voltage (U3) satisfies a condition.

7. The system (700) according to claim 6, wherein the system (700) further comprises:
an output module configured to output a warning message of the adhesion malfunction.

8. The system (700) according to any of claims 6 to 7, wherein the acquiring module (710) is configured to measure the second voltage (U3) across the load multiple times within the time period comprises the acquiring module (710) is configured to measure the second voltage (U3) across the load according to one or more sampling time intervals.

9. The system (700) according to any of claims 6 to 8, wherein the condition comprises:
a number of instances over the time period when a percentage increase in the second voltage (U3) measured in two consecutive sampling times exceeds a second threshold value is N, wherein N is a natural number; and
after the time period, a ratio of a measured second voltage (U3) to the voltage (U1) of the battery pack is greater than a third threshold value.

## Patentansprüche

1. Verfahren zum Erkennen einer Adhäsionsfehlfunktion eines Relais einer Hochspannungsschaltung (100), wobei die Hochspannungsschaltung (100) ein Batteriepack, ein erstes Relais (K1), einen Verbraucher, einen Reihenzweig und ein zweites Relais (K3) umfasst, wobei das erste Relais (K1) mit einer positiven Elektrode des Batteriepacks und mit einem ersten Ende des Verbrauchers verbunden ist, das zweite Relais (K3) mit einer negativen Elektrode des Batteriepacks und mit einem zweiten Ende des Verbrauchers verbunden ist, der Reihenzweig ein drittes Relais (K2) und einen ersten Widerstand (R1), die in Reihe geschaltet sind, einschließt, wobei das dritte Relais (K2) mit dem ersten Ende des Verbrauchers verbunden ist, und der Reihenzweig zu dem ersten Relais (K1) parallel geschaltet ist, wobei der Verbraucher einen Kondensator (C) und einen zu dem Kondensator (C) parallel geschalteten zweiten Widerstand (R2) einschließt, wobei das Verfahren Folgendes umfasst:
Messen (S401) einer ersten Spannung (U3) über den Verbraucher, wenn sowohl das erste Relais (K1) als auch das zweite Relais (K3) als auch das dritte Relais (K2) geöffnet sind;
Bestimmen, dass eine Differenz zwischen der ersten Spannung (U3) und einer Spannung (U1) des Batteriepacks größer als ein erster Schwellenwert ist, was eine Vorbedingung für das Messen einer zweiten Spannung (U3) ist,
wobei das Verfahren ferner durch Folgendes gekennzeichnet ist:
Bestimmen, dass die Differenz zwischen der ersten Spannung und der Spannung des Batteriepacks größer als ein erster Schwellenwert ist, durch Bestimmen, dass ein Verhältnis der ersten Spannung zu der Spannung des Batteriepacks kleiner als ein Schwellenwert von 50 % ist;
mehrmaliges Messen (S402) der zweiten Spannung (U3) über den Verbraucher innerhalb eines Zeitabschnitts, in dem das erste Relais (K1) und das zweite Relais (K3) geöffnet sind und das dritte Relais (K2) geschlossen ist; und
Bestimmen (S403), dass das zweite Relais (K3) die Adhäsionsfehlfunktion aufweist, wenn eine Änderung eines Werts der zweiten Spannung (U3) eine Bedingung erfüllt.

2. Verfahren nach einem der vorhergehenden Ansprüche, das ferner Folgendes umfasst:
Bestimmen, dass das zweite Relais (K3) die Adhäsionsfehlfunktion nicht aufweist, wenn die Änderung des Werts der zweiten Spannung (U3) die Bedingung nicht erfüllt.

3. Verfahren nach einem der vorhergehenden Ansprüche, das ferner Folgendes umfasst:
Ausgeben einer Warnmeldung der Adhäsionsfehlfunktion, sobald das zweite Relais (K3) die Adhäsionsfehlfunktion aufweist.

4. Verfahren nach einem der vorhergehenden Ansprüche, wobei das mehrmalige Messen der zweiten Spannung (U3) über den Verbraucher innerhalb des vorgegebenen Zeitabschnitts umfasst, dass die zweite Spannung (U3) über den Verbraucher in Abhängigkeit von einem oder mehreren Abtastzeitintervallen gemessen wird.

5. Verfahren nach einem der vorhergehenden Ansprüche, wobei die Bedingung Folgendes umfasst:
eine Anzahl von Fällen während des Zeitabschnitts, in dem eine prozentuale Erhöhung der in zwei aufeinanderfolgenden Abtastzeiten gemessenen zweiten Spannung (U3) einen zweiten Schwellenwert überschreitet, ist N, wobei N eine natürliche Zahl ist; und
nach dem Zeitabschnitt ist ein Verhältnis einer gemessenen zweiten Spannung (U3) zu der Spannung (U1) des Batteriepacks größer als ein dritter Schwellenwert.

6. System (700), das eine Hochspannungsschaltung (100) umfasst, wobei das System konfiguriert ist, um eine Adhäsionsfehlfunktion eines Relais der Hochspannungsschaltung (100) zu erkennen, wobei die Hochspannungsschaltung (100) ein Batteriepack, ein erstes Relais (K1), einen Verbraucher, einen Reihenzweig und ein zweites Relais (K3) umfasst, wobei das erste Relais (K1) mit einer positiven Elektrode des Batteriepacks und mit einem ersten Ende des Verbrauchers verbunden ist, das zweite Relais (K3) mit einer negativen Elektrode des Batteriepacks und mit einem zweiten Ende des Verbrauchers verbunden ist, der Reihenzweig ein drittes Relais (K2) und einen ersten Widerstand (R1), die in Reihe geschaltet sind, einschließt, wobei das dritte Relais (K2) mit dem ersten Ende des Verbrauchers verbunden ist, und der Reihenzweig zu dem ersten Relais (K1) parallel geschaltet ist, wobei der Verbraucher einen Kondensator (C) und einen zu dem Kondensator (C) parallel geschalteten zweiten Widerstand (R2) einschließt, wobei das System Folgendes umfasst:
ein Erfassungsmodul (710), das konfiguriert ist, um eine erste Spannung (U3) über den Verbraucher zu messen, wenn sowohl das erste Relais (K1) als auch das zweite Relais (K3) als auch das dritte Relais (K2) geöffnet sind;
wobei das Erfassungsmodul (710) ferner konfiguriert ist, um zu bestimmen, dass eine Differenz zwischen der ersten Spannung (U3) und einer Spannung (U1) des Batteriepacks größer als ein erster Schwellenwert ist, was eine Vorbedingung dafür ist, dass das Erfassungsmodul (710) konfiguriert ist, um eine zweite Spannung (U3) zu messen,
**dadurch gekennzeichnet, dass** das Erfassungsmodul konfiguriert ist, um zu bestimmen, dass die Differenz zwischen der ersten Spannung und der Spannung des Batteriepacks größer als ein erster Schwellenwert ist, indem es bestimmt, dass ein Verhältnis der ersten Spannung zu der Spannung des Batteriepacks kleiner als ein Schwellenwert von 50 % ist;
wobei das Erfassungsmodul (710) ferner konfiguriert ist, um die zweite Spannung (U3) über den Verbraucher innerhalb eines Zeitabschnitts, in dem das erste Relais (K1) und das zweite Relais (K3) geöffnet sind und das dritte Relais (K2) geschlossen ist, mehrmals zu messen; und
ein Bestimmungsmodul (720), das konfiguriert ist, um zu bestimmen, dass das zweite Relais (K3) die Adhäsionsfehlfunktion aufweist, wenn eine Änderung eines Werts der zweiten Spannung (U3) eine Bedingung erfüllt.

7. System (700) nach Anspruch 6, wobei das System (700) ferner Folgendes umfasst:
ein Ausgabemodul, das konfiguriert ist, um eine Warnmeldung der Adhäsionsfehlfunktion auszugeben.

8. System (700) nach einem der Ansprüche 6 bis 7, wobei dass das Erfassungsmodul (710) konfiguriert ist, um die zweite Spannung (U3) über den Verbraucher innerhalb des Zeitabschnitts mehrmals zu messen, umfasst, dass das Erfassungsmodul (710) konfiguriert ist, um die zweite Spannung (U3) über den Verbraucher in Abhängigkeit von einem oder mehreren Abtastzeitintervallen zu messen.

9. System (700) nach einem der Ansprüche 6 bis 8, wobei die Bedingung Folgendes umfasst:
eine Anzahl von Fällen während des Zeitabschnitts, in dem eine prozentuale Erhöhung der in zwei aufeinanderfolgenden Abtastzeiten gemessenen zweiten Spannung (U3) einen zweiten Schwellenwert überschreitet, ist N, wobei N eine natürliche Zahl ist; und
nach dem Zeitabschnitt ist ein Verhältnis einer gemessenen zweiten Spannung (U3) zu der Spannung (U1) des Batteriepacks größer als ein dritter Schwellenwert.

## Revendications

1. Procédé de détection d'un dysfonctionnement d'adhérence d'un relais d'un circuit haute tension (100), le circuit haute tension (100) comprenant un bloc-batterie, un premier relais (K1), une charge, une ramification en série, et un deuxième relais (K3), dans lequel le premier relais (K1) est connecté entre une électrode positive du bloc-batterie et à une première extrémité de la charge, le deuxième relais (K3) est connecté entre une électrode négative du bloc-batterie et à une seconde extrémité de la charge, la ramification en série inclut un troisième relais (K2) et une première résistance (R1) connectés en série, le troisième relais (K2) se connectant à la première extrémité de la charge, et la ramification en série étant connectée en parallèle du premier relais (K1), la charge incluant un condensateur (C) et une deuxième résistance (R2) connectée en parallèle du condensateur (C), le procédé comprenant les étapes consistant à :
mesurer (S401) une première tension (U3) sur la charge quand le premier relais (K1), le deuxième relais (K3), et le troisième relais (K2) sont tous ouverts ;
déterminer qu'une différence entre la première tension (U3) et une tension (U1) du bloc-batterie est supérieure à une première valeur seuil comme une condition préalable à la mesure d'une deuxième tension (U3), le procédé étant en outre **caractérisé par** la détermination que la différence entre la première tension et la tension du bloc-batterie est supérieure à une première valeur seuil en déterminant qu'un rapport de la première tension à la tension du bloc-batterie est inférieur à une valeur seuil de 50 % ;
mesurer (S402) la deuxième tension (U3) sur la charge à de multiples reprises au sein d'une période de temps quand le premier relais (K1) et le deuxième relais (K3) sont ouverts et le troisième relais (K2) est fermé ; et
déterminer (S403) que le deuxième relais (K3) présente le dysfonctionnement d'adhérence lorsqu'un changement dans une valeur de la deuxième tension (U3) satisfait une condition.

2. Procédé selon l'une quelconque des revendications précédentes comprenant en outre une étape consistant à :
déterminer que le deuxième relais (K3) ne présente pas le dysfonctionnement d'adhérence lorsque le changement dans la valeur de la deuxième tension (U3) ne satisfait pas la condition.

3. Procédé selon l'une quelconque des revendications précédentes comprenant en outre une étape consistant à :
émettre un message d'avertissement du dysfonctionnement d'adhérence après que le deuxième relais (K3) présente le dysfonctionnement d'adhérence.

4. Procédé selon l'une quelconque des revendications précédentes, dans lequel la mesure de la deuxième tension (U3) sur la charge à de multiples reprises au sein de la période de temps spécifiée comprend l'étape consistant à mesurer la deuxième tension (U3) sur la charge selon un ou plusieurs intervalles de temps d'échantillonnage.

5. Procédé selon l'une quelconque des revendications précédentes, dans lequel la condition comprend :
un nombre d'instances sur la période de temps où une augmentation de pourcentage de la deuxième tension (U3) mesurée dans deux périodes d'échantillonnage consécutives dépasse une deuxième valeur seuil est N, N étant un nombre naturel ; et
après la période de temps, un rapport d'une deuxième tension mesurée (U3) à la tension (U1) du bloc-batterie est supérieur à une troisième valeur seuil.

6. Système (700) comprenant un circuit haute tension (100), le système étant configuré pour détecter un dysfonctionnement d'adhérence d'un relais du circuit haute tension (100), le circuit haute tension (100) comprenant un bloc-batterie, un premier relais (K1), une charge, une ramification en série, et un deuxième relais (K3), dans lequel le premier relais (K1) est connecté entre une électrode positive du bloc-batterie et à une première extrémité de la charge, le deuxième relais (K3) est connecté entre une électrode négative du bloc-batterie et à une seconde extrémité de la charge, la ramification en série inclut un troisième relais (K2) et une première résistance (R1) connectés en série, le troisième relais (K2) se connectant à la première extrémité de la charge, et la ramification en série étant connectée en parallèle du premier relais (K1), la charge incluant un condensateur (C) et une deuxième résistance (R2) connectée en parallèle du condensateur (C), le système comprenant :
un module d'acquisition (710) configuré pour mesurer une première tension (U3) sur la charge quand le premier relais (K1), le deuxième relais (K3), et le troisième relais (K2) sont tous ouverts ;
le module d'acquisition (710) étant en outre configuré pour déterminer qu'une différence entre la première tension (U3) et une tension (U1) du bloc-batterie est supérieure à une première valeur seuil comme une condition préalable à ce que le module d'acquisition (710) soit configuré pour mesurer une deuxième tension (U3), **caractérisé en ce que** le module d'acquisition est configuré pour déterminer que la différence entre la première tension et la tension du bloc-batterie est supérieure à une première valeur seuil en déterminant qu'un rapport de la première tension à la tension du bloc-batterie est inférieur à une valeur seuil de 50 % ;
le module d'acquisition (710) étant en outre configuré pour mesurer la deuxième tension (U3) sur la charge à de multiples reprises au sein d'une période de temps quand le premier relais (K1) et le deuxième relais (K3) sont ouverts et le troisième relais (K2) est fermé ; et
un module de détermination (720) configuré pour déterminer que le deuxième relais (K3) présente le dysfonctionnement d'adhérence lorsqu'un changement dans une valeur de la deuxième tension (U3) satisfait une condition.

7. Système (700) selon la revendication 6, dans lequel le système (700) comprend outre :
un module de sortie configuré pour émettre un message d'avertissement du dysfonctionnement d'adhérence.

8. Système (700) selon l'une quelconque des revendications 6 à 7, dans lequel le fait que le module d'acquisition (710) est configuré pour mesurer la deuxième tension (U3) sur la charge à de multiples reprises au sein de la période de temps comprend le fait que le module d'acquisition (710) est configuré pour mesurer la deuxième tension (U3) sur la charge selon un ou plusieurs intervalles de temps d'échantillonnage.

9. Système (700) selon l'une quelconque des revendications 6 à 8, dans lequel la condition comprend :
un nombre d'instances sur la période de temps où une augmentation de pourcentage de la deuxième tension (U3) mesurée dans deux périodes d'échantillonnage consécutives dépasse une deuxième valeur seuil est N, N étant un nombre naturel ; et
après la période de temps, un rapport d'une deuxième tension mesurée (U3) à la tension (U1) du bloc-batterie est supérieur à une troisième valeur seuil.
